# EUROPEAN PATENT SPECIFICATION

(11) **EP 3 073 808 B1**
(45) Date of publication and mention of the grant of the patent: **23.09.2020**
(21) Application number: 14863952.9
(22) Date of filing: 12.11.2014
(51) Int. Cl.: H05H 1/46, C23C 16/50, H01J 37/32, H01J 37/34

(54) **PLASMA CVD DEVICE AND METHOD FOR MANUFACTURING A SUBSTRATE WITH A THIN FILM**
PLASMA-CVD-VORRICHTUNG UND VERFAHREN ZUR HERSTELLUNG EINES SUBSTRATES MIT EINER DÜNNSCHICHT
DISPOSITIF DE CVD AU PLASMA ET PROCÉDÉ DE FABRICATION D'UN SUBSTRAT À FILM MINCE

(30) Priority: 22.11.2013 JP 2013241641
(43) Date of publication of application: 28.09.2016
(73) Proprietor: Toray Industries, Inc., Tokyo, 103-8666 (JP)
(72) Inventor: KAWASHITA, Mamoru, Otsu-shi, Shiga 520-8558 (JP); EJIRI, Hiroe, Otsu-shi, Shiga 520-8558 (JP)
(74) Representative: Hoefer & Partner Patentanwälte mbB
(86) International application number: PCT/JP2014/079940
(87) International publication number: WO 2015/076162

(56) References cited:
- EP-A1- 0 045 822
- EP-A2- 0 084 970
- WO-A1-2012/114941
- WO-A1-2014/142023
- JP-A- S4 926 184
- JP-A- S6 179 224
- JP-A- S57 114 663
- JP-A- S58 151 028

## Description

### Technical Field of the Invention

The invention relates to a plasma CVD device and a manufacturing process of a substrate.

### Background Art of the Invention

It is generally known that surfaces of substrates can be reformed with plasma and that function film can be formed on the surface of substrates with a film depositing means using plasma. To provide plasma used for these technologies, various plasma electrodes have been developed and put into practical use. From a viewpoint of efficiency, the electrode technology for generating plasma on both sides of an electrode has been developed.

Patent document 1 discloses an electrode having two magnetic circuits back to back to generate plasma on both sides of the electrode so that a sputtering film deposition can be performed on both sides at the same time. With this technology, the sputtering film deposition can be performed on both sides of cathode comprising two cathodes integrated back to back, and the film deposition can be performed efficiently by feeding substrates in each film depositing zone.

Patent document 2 discloses an electrode structure having a magnetic circuit without yokes to generate magnetic field at both sides of the electrode for magnetron electric discharge. With this electrode, sputtering film deposition can be performed on both sides of cathode. This electrode doesn't have a yoke so that the magnetic flux density is distributed equally at the electric discharge surface side and its opposite side although conventional one has a yoke to induce the magnetic flux at the opposite side. This electrode makes it possible to perform two passes of sputtering film deposition per one electrode because another target surface can be provided at the opposite side of the electric discharge surface side to perform sputtering film deposition on both sides.

Patent document 3 discloses an electrode structure having a magnet unit to generate magnetic field at both sides for magnetron electric discharge so that sputtering film deposition can be performed on both sides of cathode. With this electrode having a magnetic circuit with a yoke to actively induce the magnetic flux for optimizing the magnetic flux density distribution, sputtering film deposition can be performed on both sides of cathode in the same way as in Patent document 2.

### Prior art documents

### Patent documents

Patent document 1: JP2004-27272-A
Patent document 2: JP2006-233240-A
Patent document 3: JP2009-127109-A

Prior art document EP 0 084 970 A2 discloses a magnetically enhanced plasma process and apparatus which are configured in order to increase the efficiency of plasma etching by providing a confining magnetic field which is close to an underlying substrate support electrode. The electrode has a prismatic body with at least two flat faces. Magnetic pole pieces of opposite polarity project beyond the faces at opposite ends of the body and extend completely around the body and are configured in order to create magnetic field that extends parallel the to the flat faces and surrounds the body like a belt.

Prior art document WO 2014/142023 A1 describes a plasma CVD device and method wherein a vacuum vessel, a plasma CVD electrode unit and a substrate-holding mechanism inside the vacuum vessel are involved . The plasma CVD electrode unit is provided with an anode, a cathode that faces the anode at a distance, and a first gas supply nozzle for supplying gas so as to pass through the plasma-forming space between the anode and cathode. A substrate-holding mechanism is disposed at a position where the gas passing through the plasma-forming space impinges. The length of the anode in the direction of gas supply and the length of the cathode in the direction of gas supply are both longer than the distance between the anode and the cathode.

### Summary of the Invention

### Problems to be solved by the Invention

Patent documents 1-3 have suggested sputtering electrodes having an electrode structure capable of generating plasma on both sides of cathode for efficient sputtering film deposition. However, there hasn't been any efficient plasma source suggested suitably for a use such as plasma processing and plasma CVD, other than the sputtering film deposition. When the sputtering electrodes disclosed in Patent documents 1-3 are used for plasma processing or plasma CVD, generated plasma might have different intensities between both sides of cathode or plasma might be generated on one side only, and therefore electric discharge might not be achieved stably and equally on both sides. Although that may not be a big problem on a sputtering device to form one layer of film on one electric discharge surface, it could cause a poor controllability, on a plasma processing or plasma CVD electrode which generates two kinds of plasma for a single processing.

### Means for solving the Problems

The object underlying the present invention is achieved by a plasma CVD device according to independent claim 1, and by a manufacturing process according to independent claim 8. Preferred embodiments are defined in the respective dependent claims.

### Effect according to the Invention

The invention can provide a plasma source efficient in terms of installation space and productivity to achieve high-speed plasma processing and plasma CVD film deposition relative to conventional technologies.

### Brief explanation of the drawings

[Fig. 1] Fig. 1 is a schematic section view showing an example of an electrode main body according to the invention.
[Fig. 2] Fig. 2 is a schematic section view showing another example of an electrode main body according to the invention.
[Fig. 3] Fig. 3 is a schematic section view showing yet another example of an electrode main body according to the invention.
[Fig. 4a] Fig. 4a is a schematic section view showing an example of a plasma processing electrode according to the invention.
[Fig. 4b] Fig. 4b is a schematic section view showing another example of a plasma processing electrode according to the invention.
[Fig. 5] Fig. 5 is a schematic diagram showing the section viewed in I-I arrow direction of the plasma processing electrode shown in Fig. 4a.
[Fig. 6a] Fig. 6a is a schematic section view showing an example of a plasma CVD electrode according to the invention.
[Fig. 6b] Fig. 6b is a schematic section view showing another example of a plasma CVD electrode according to the invention.
[Fig. 7] Fig. 7 is a perspective view of a magnetic field analysis model of main body of cathode provided in a plasma electrode of the invention.
[Fig. 8] Fig. 8 is a sectional side view showing a magnetic field analysis result of the analysis model shown in Fig. 7.
[Fig. 9] Fig. 9 is a front view showing a magnetic field analysis result of the analysis model shown in Fig. 7.

### Embodiments for carrying out the Invention

Hereinafter, embodiments of the invention will be explained with reference to the figures, although the invention should not be limited to any embodiment.

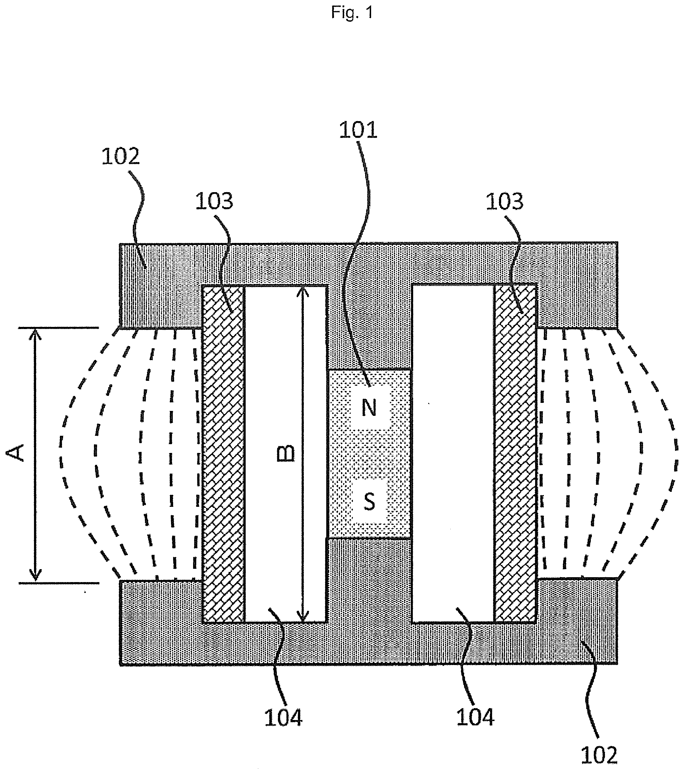

Fig. 1 is a schematic section view showing an example of an electrode main body according to the invention. The electrode main body comprises magnet 101, yoke 102 and cathode 103. Magnetic flux generated by magnet 101 is induced by yoke 102 and discharged onto cathode 103, so that magnetic field for magnetron is formed on an electric discharge surface of cathode 103. Cathode 103 is disposed with its surface facing outward while surrounding magnet 101. There are three options of layout in which: (i) one cathode 103 surrounds magnet 101; (ii) a plurality of cathodes 103 surround magnet 101 without each interval and; (iii) a plurality of cathodes 103 surround magnet 101 with each interval. Option (i) is a kind of layout in which cathode 103 is disposed around magnet 103 without any interval. Thus cathode 103 surrounds magnet 101 so that the magnetic field for magnetron formed on the electric discharge surface of cathode 103 is generated continuously to surround the main body of electrode.

The plasma processing electrode comprises a ground member facing cathode 103 with interval. High-density plasma is generated on the surface of cathode 103 by applying electric field between cathode 103 and ground member. The plasma is generated to surround the main body of electrode since the magnetic field for magnetron formed on the electric discharge surface of cathode 103 is generated continuously to surround the main body of electrode as described above. Such a plasma stably connected continuously can prevent troubles, such as plasma generation failure at one side and unbalanced intensity of plasma generated at both sides of the main body of electrode. The ground member may not be disposed to face all cathodes 103, and may be disposed to face some cathodes 103 beyond the main body of electrode. It is preferable that the ground member is disposed to surround the main body of electrode so that plasma generated to surround the main body of electrode is more stable.

The electrode main body may have refrigerant flow path 104 as a space surrounded by magnetic field generation means 101, yoke 102 and cathode 103. Refrigerant flow path 104 can be cooled off by flowing refrigerant therein to prevent magnet 101 and cathode 103 from being heat damaged with discharge.

Magnet 101 may be designed appropriately in kind and shape so that tunnel-shaped magnetic flux develops on the surface of cathode 103 with sufficient intensity. It is preferable that magnet 101 is a ferrite magnet, a samarium cobalt magnet or a neodymium magnet. Magnet 101 can be formed into a shape corresponding to the shape of electrode. For example, it is preferable that a round-shaped magnet is provided in a small round-shaped electrode. A rectangular magnet may generally be provided in the rectangular electrode. A large magnet with which a wide electrode is provided might have a poor handling ability in assembly work because of its strong magnetic force. In such a case, it is generally preferable that a plurality of rectangular magnets are disposed in a line to form a group of magnets.

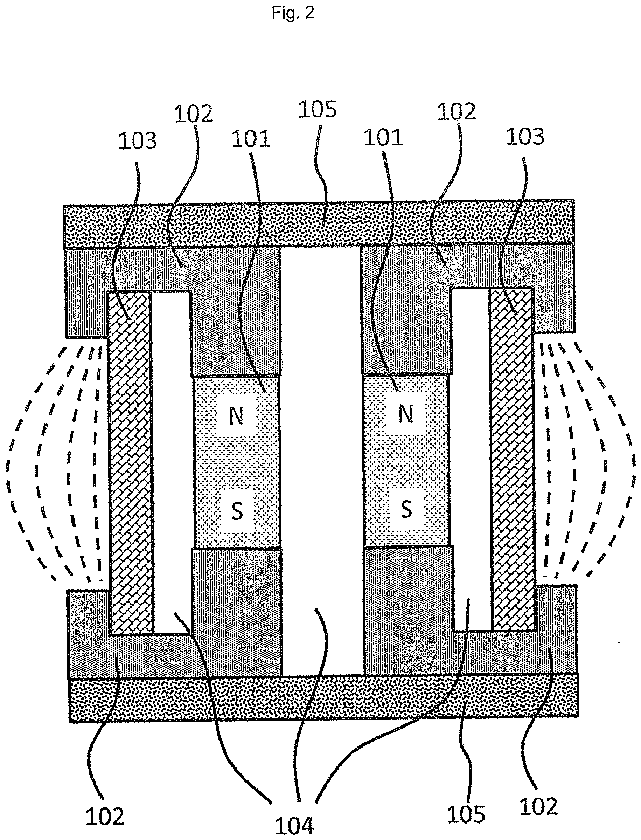

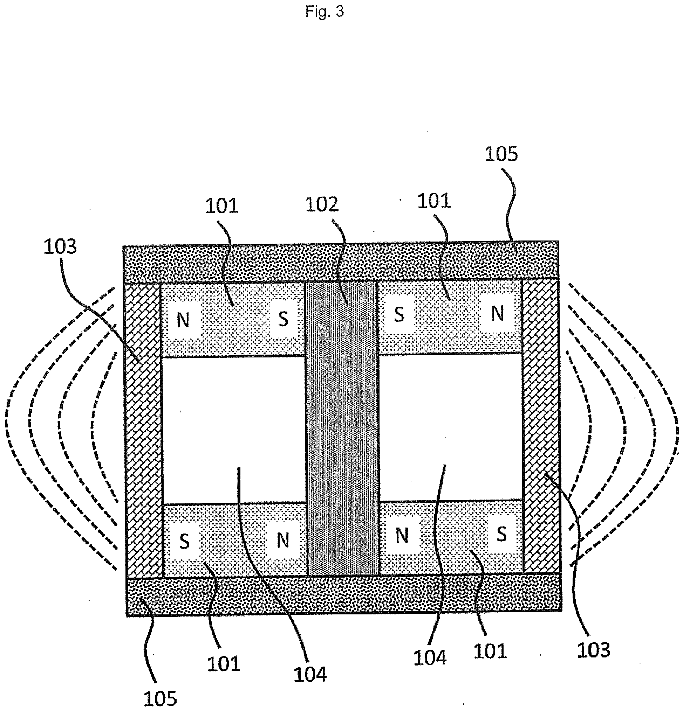

The layout of magnet 101 and yoke 102 can be designed appropriately according to configuration of the magnetic circuit. In a case of magnetic circuit shown in Fig. 1 where magnetic flux discharged from magnet 101 is induced onto the surface of each cathode 103 at both sides with yoke 102, it is preferable that magnet 101 is disposed in the center as shown in Fig. 1. Fig. 2 and Fig. 3 are schematic section view showing other examples of electrode main bodies according to the invention. In a case of two systems of magnetic circuits shown in Fig. 2 where each magnetic flux discharged from magnet 101 is induced onto the surface of each cathode 103 at one side with yoke 102, it is preferable that each magnet 101 is disposed with respect to each system of magnetic circuit as shown in Fig. 2. In a case of two systems of magnetic circuits shown in Fig. 3 where each magnetic flux discharged from a pair of magnets 101 is induced onto the surface of each cathode 103 at one side, it is preferable that each pair of magnets 101 is disposed with respect to each system of magnetic circuit in two systems of magnetic circuits configured with yoke 102 as shown in Fig. 3.

Cathode 103 may be made of a material selected appropriately according to the use of electrode. For example, when the electrode main body is intended to be used for a sputtering equipment, it is preferable that cathode 103 has an outermost layer containing a sputtering target material at the electric discharge side. Alternatively, when the electrode main body is used as a plasma generation source such as ion source, it is preferable that cathode 103 is made of a material such as aluminum and titanium having a low sputtering rate to prevent cathode 103 from eroding with plasma. In both cases, it is preferable that cathode 103 is cooled off with any cooling means, and it is more preferable that cathode 103 in itself is cooled directly with refrigerant.

As shown in Fig. 1 and Fig. 2, an outer side end of yoke 102 can be protruded outer than the surface of cathode 103, which is the electric discharge surface of the main body of electrode, so that the protrusion functions as an auxiliary magnetic pole. It is preferable that such an auxiliary magnetic pole is provided, so that controllability of the magnetic field on cathode 103 is improved. For example, the auxiliary magnetic pole can be designed to generate magnetic field rising up steeply in a narrow span between magnetic poles to generate high-density plasma concentrated in the narrow area. Alternatively, the auxiliary magnetic pole can be designed to generate magnetic field less fluctuating in magnetic field intensity in a wide span between magnetic poles to generate wide plasma. It is preferable to design the magnetic field depending on the purpose of use of the electrode appropriately in this way, In a case of providing the auxiliary magnetic pole, it is preferable that pole span A shown in Fig. 1 is shorter than refrigerant flow path width B. This is because such a configuration can focus the discharge of magnetic flux induced with the yoke as much as possible on the auxiliary magnetic pole.

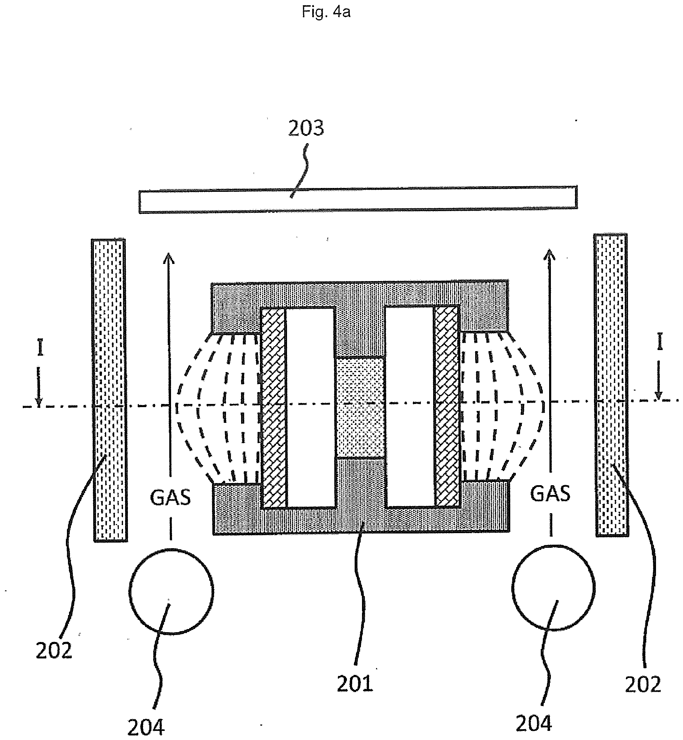

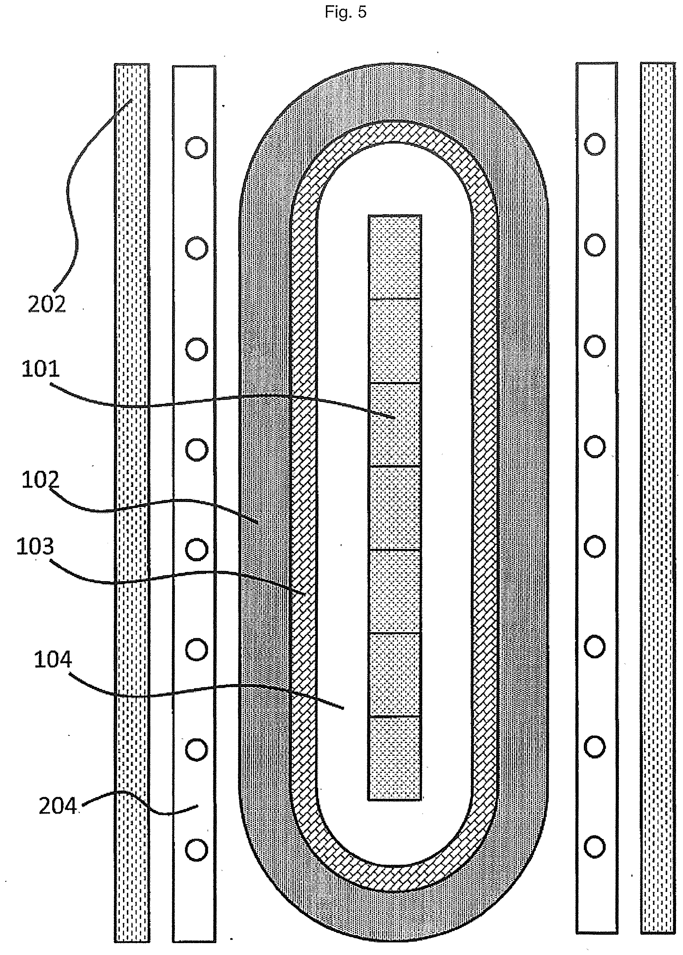

Fig. 4a is a schematic section view showing an example of a plasma processing electrode according to the invention. Fig. 5 is a schematic diagram showing the section viewed in I-I arrow direction of the plasma processing electrode shown in Fig. 4a. This plasma processing electrode is provided with ground members 202 sandwiching electrode 201 as leaving spaces therebetween while electrode 201 is configured as shown in Fig. 1. Further, it is provided with gas nozzles 204 which introduce gas in a direction parallel to the electric discharge surface of cathode 103 between the electric discharge surface and ground members 202. Substrate 203 is supported by a supporting mechanism (not shown) in a position distant from electrode 201 on a line (gas downstream side) extended along the gas introduction direction of gas nozzle 204 and is processed on its surface with plasma. The supporting mechanism of substrate may be fixed or movable to convey substrate 203 through a cylindrical drum shaped body.

Gas nozzle 204 is provided to introduce gas directly into a space ionized by electrode 201 so that the introduced gas is ionized efficiently. In addition, it can orient the gas introduction flow so that ion and radical generated in the ionized space are utilized efficiently. It is therefore preferable that the plasma processing electrode is provided in a plasma processing device such as ion source and radical source, and is preferably provided in a plasma CVD electrode.

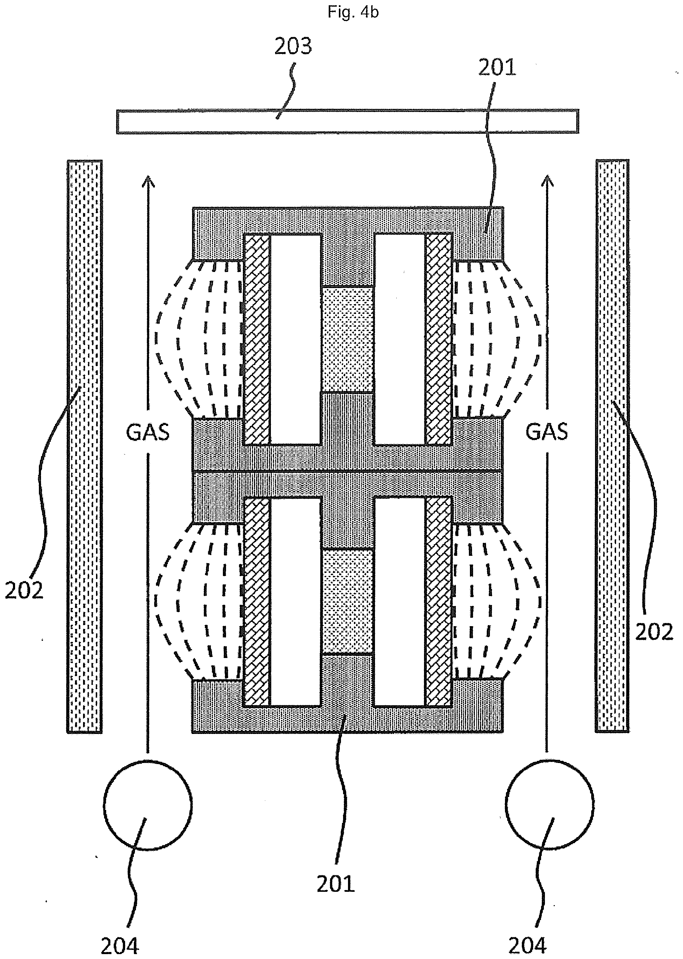

Fig. 4b is a schematic section view showing another example of a plasma processing electrode according to the invention. This plasma electrode unit comprises two basic units of electrode 201 shown in Fig. 1 disposed along the flow direction of gas introduced from gas nozzle 204. With such disposed two basic units, the introduced gas is exposed for a long time by high density plasma and resolved acceleratingly. Thus increasingly produced ion and radical contribute to the improvement in processing performance of plasma processing device and film deposition speedup of plasma CVD device. Further, three or more basic units may be disposed in the plasma processing electrode although only two basic units are disposed in Fig. 4b.

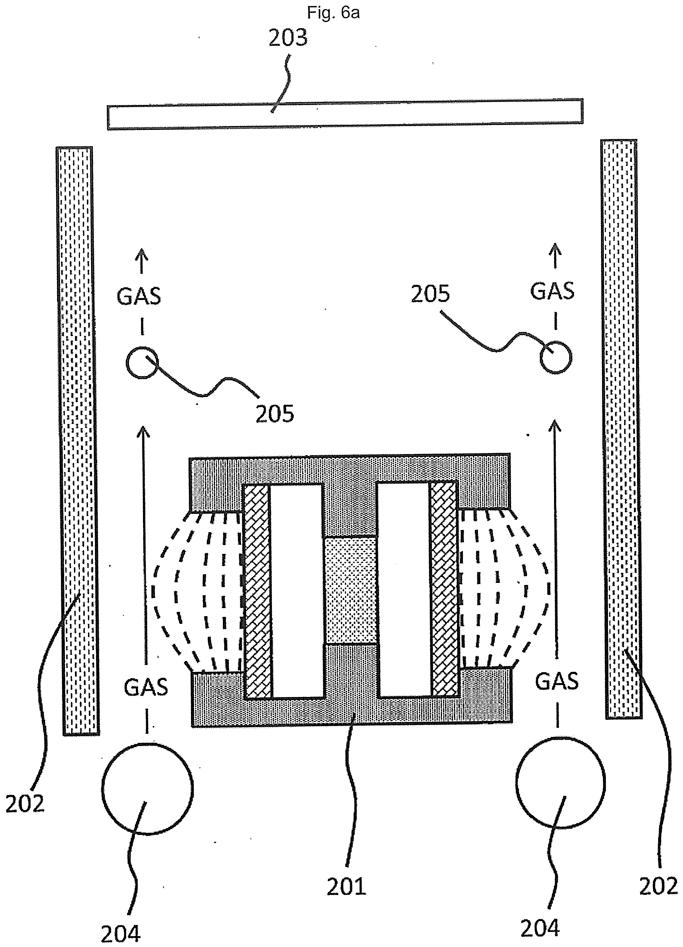

Fig. 6a is a schematic section view showing an example of a plasma CVD electrode according to the invention. In addition to the configuration of plasma processing electrode shown in Fig. 4a, source gas nozzles 205 to feed CVD source gases are further provided opposite to gas nozzle 204 from the electric discharge space. Using this plasma processing electrode, plasma is generated with a plasma electrode in the electric discharge space. Gas is introduced through gas nozzle 204 toward the electric discharge space and ionized. The ionized gas is fed onto substrate 203 while CVD source gases are fed onto substrate 203 through source gas nozzle 205, so that the CVD gases are resolved to deposit a thin film on substrate 203.

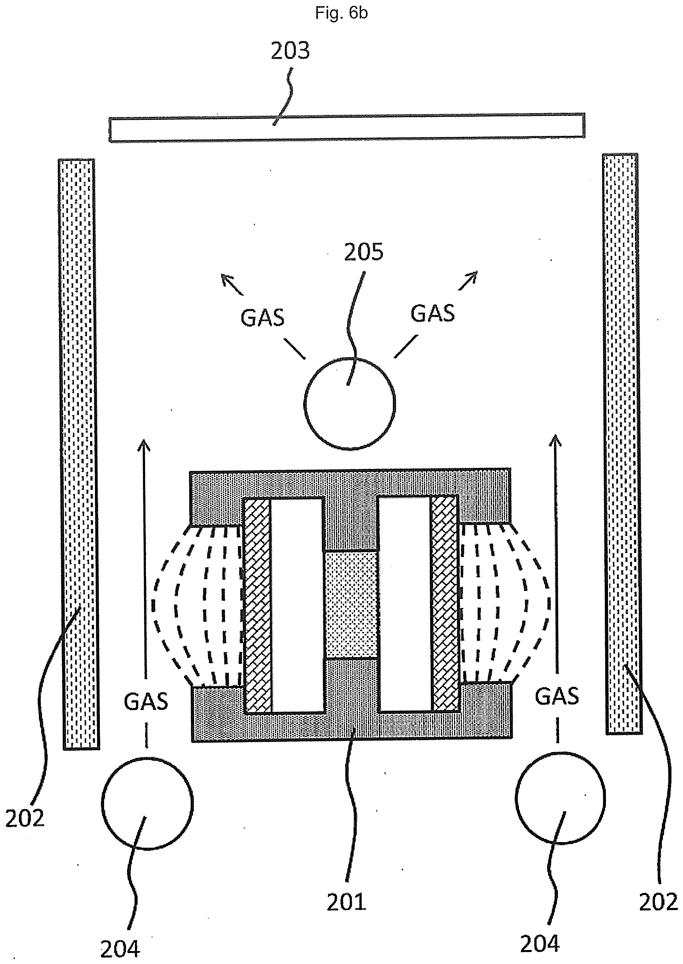

Fig. 6b is a schematic section view showing another example of a plasma CVD electrode according to the invention. In addition to the configuration of plasma processing electrode shown in Fig. 4a, source gas nozzle 205 to feed CVD source gases is further provided in a space between the main body of electrode 201 and substrate 203. Using this plasma processing electrode, plasma is generated with a plasma electrode in the electric discharge space. Gas is introduced through gas nozzle 204 toward the electric discharge space and ionized. The ionized gas is fed into the space between the main body of electrode 201 and substrate 203 while CVD source gases are fed into the space through source gas nozzle 205, so that the CVD gases are resolved to deposit a thin film on substrate 203.

The plasma CVD electrodes shown in Fig. 6a and Fig. 6b are provided with source gas nozzle 205 downstream of basic gas flow from the electric discharge space, so that film depositing seeds are prevented from flowing back and electrode 201 is prevented from being contaminated. Further, substrate 203 can be kept away from the electric discharge space so that a film deposition is performed with less damage by preventing the thermal damage and ion bombardment caused by plasma. From a viewpoint of easy handling of components such as source gas nozzle 205, it is preferable that a minimum distance between the center of the electric discharge space and substrate 203 is 30mm or more. When the distance between the center of the electric discharge space and substrate 203 is longer than 300mm, the film depositing rate might be deteriorated to increase the occupied space and decrease efficiency. Therefore it is preferable that the distance is 300mm or less.

To remove charged particles damaging the substrate and deposited film, it is preferable that an electrically-grounded mesh conductor is provided between electrode 201 and a position to place substrate 203. To prevent the film depositing ability from deteriorating by blocking the passage of products other than the charged particles, it is preferable that the mesh opening rate is 50% or more.

### [Example]

Hereinafter, magnetic circuit analysis results of the plasma electrode described above will be shown as follows.

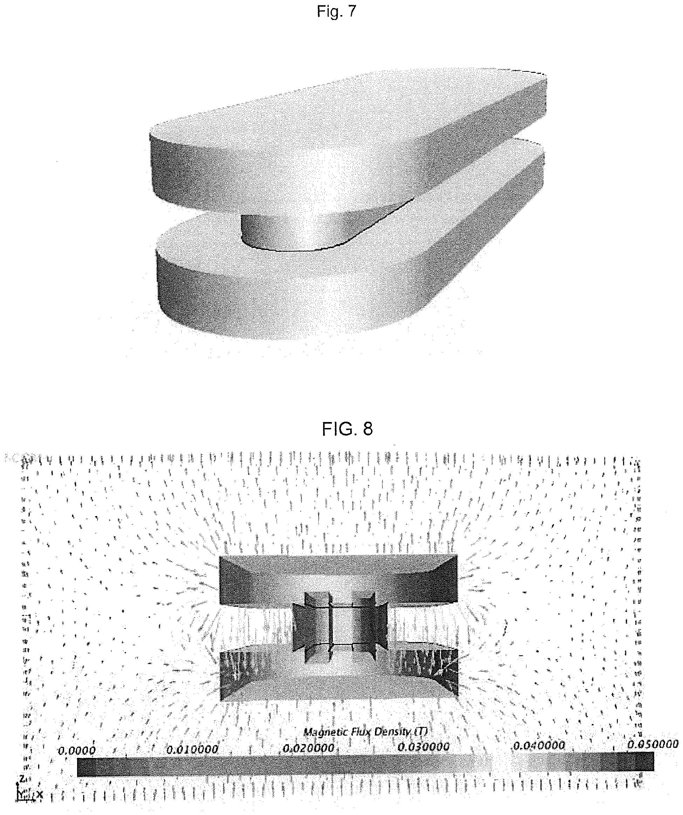

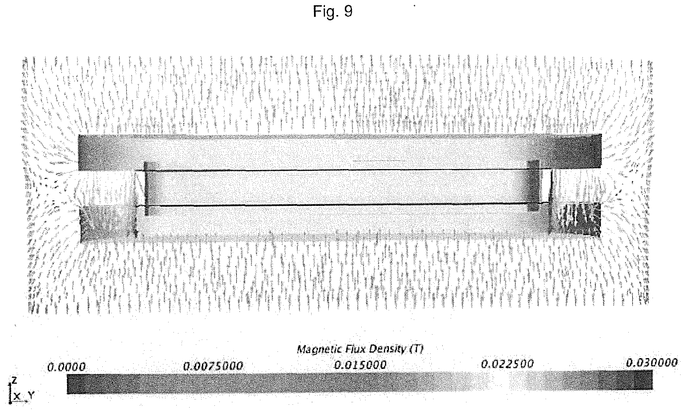

The main body of electrode shown in Fig. 1 was employed. The analysis was performed under an assumption such that magnet 101 comprises neodymium magnets each having a size of 20mm in height (in the magnetization direction), 10mm in width and 40mm in length and that the magnet surface magnetic flux density is 300mT. It was also assumed that yoke 102 is made of ferrite-based stainless steel SUS430 and specific magnetic permeability is 500 (absolute magnetic permeability of 1.26 x 10⁻⁶ x 500H/m). It is further assumed that cathode 103 is made of pure titanium and coolant water flows in refrigerant flow path 104. The analysis model shown in Fig. 7 was analyzed with STAR-CCM+Ver.7.04.011 under the above-described assumption. The result of analysis showed that a tunnel-shaped magnetic flux is formed to surround a cathode. Fig. 8 and Fig. 9 show the magnetic flux density distribution. Such a cathode can generate plasma which is stable enough to prevent the plasma intensity from being greatly different between both linear sections.

### Industrial Applications of the Invention

The invention is applicable to a plasma CVD device and a manufacturing process of a substrate.

### Explanation of symbols

- 101:: magnet
- 102:: yoke
- 103:: cathode
- 104:: refrigerant flow path
- 105:: casing
- 201:: electrode
- 202:: ground member
- 203:: substrate
- 204:: gas nozzle
- 205:: source gas nozzle
- A:: pole span
- B:: refrigerant flow path width

## Claims

1. A plasma CVD device,
- comprising:
- a vacuum chamber,
- a CVD electrode provided in the vacuum chamber, and
- a supporting mechanism,
- wherein:
- the CVD electrode comprises a plasma processing electrode and a source gas nozzle (205) configured to introduce a CVD source gas into a neighborhood of an electrode main body (201) of the plasma processing electrode,
- the plasma processing electrode comprises the electrode main body (201), ground members (202), and a gas nozzle (204),
- the electrode main body (201) comprises a discharge surface on an outer circumference surface thereof and a magnet (101) provided inside configured to form a tunnel-shaped magnetic field continuously surrounding the electrode main body (201), when viewing the electrode main body (201) From the supporting mechanism's side, on the discharge surface,
- the electrode main body (201) further comprises a cathode (103) comprising the discharge surface on a surface thereof and a yoke (102) configured to induce magnet flux generated by the magnet (101) onto the cathode (103),
- the ground members (202) face at least a portion of the discharge surface with a gap therebetween and face each other so as to sandwich the electrode main body (201) therebetween,
- the discharge surface surrounds the outer circumference surface of the electrode main body (201), either with or without a gap interposed therebetween, when viewing the electrode main body (201) from the supporting mechanism's side,
- the gas nozzle (204) is configured to introduce a gas in a direction parallel to the electric discharge surface into an electric discharge space between the ground member (202) and the electric discharge surface facing the ground member (202), and
- the supporting mechanism is configured to support a substrate (203) placed in a position which is distant from the electrode main body (201) and which is downstream in a flow direction of the gas discharged from the gas nozzle (204).

2. The plasma CVD device according to claim 1, wherein the plasma processing electrode comprises an auxiliary magnetic pole of which outer side end is protruded outer than the electric discharge surface of the electrode main body.

3. The plasma CVD device according to any one of the preceding claims, wherein the ground member (202) surrounds the electrode main body.

4. The plasma CVD device according to any one of the preceding claims, wherein the source gas nozzle (205) is provided opposite to the gas nozzle (204) with respect to the electric discharge space.

5. The plasma CVD device according to any one of claims 1 to 3, wherein the source gas nozzle (205) is provided in a space between the electrode main body and the position to place a substrate (203) supported by the supporting mechanism.

6. The plasma CVD device according to any one of the preceding claims, wherein a minimum distance between the position to place a substrate (203) supported by the supporting mechanism and the electrode main body is 30 mm or more and 300 mm or less.

7. The plasma CVD device according to any one of the preceding claims, wherein an electrically-grounded mesh having an opening rate of 50% or more is provided between the electrode main body and the position to place a substrate (203) supported by the supporting mechanism.

8. A manufacturing process of a substrate (203) with a thin film, comprising:
- providing a plasma CVD device according to any of the preceding claims;
- a plasma generation step to generate a plasma in the plasma CVD device;
- a gas feeding step to resolve the gas introduced through the plasma from the gas nozzle (204) and feed a radical generated onto the substrate (203);
- a CVD source gas feeding step to feed the CVD source gas introduced from the source gas nozzle (205) onto the substrate (203) to deposit a thin film on the substrate (203).

## Patentansprüche

1. Plasma-CVD-Vorrichtung, die
- eine Vakuumkammer,
- eine in der Vakuumkammer vorgesehene CVD-Elektrode, und
- einen Trägermechanismus aufweist,
- wobei:
- die CVD-Elektrode eine Plasmabearbeitungselektrode und eine Quellgasdüse (205) aufweist, die konfiguriert ist, um ein CVD-Quellgas in eine Nachbarschaft eines Elektrodenhauptkörpers (201) der Plasmabearbeitungselektrode einzuführen,
- die Plasmabearbeitungselektrode den Elektrodenhauptkörper (201), Erdungselemente (202), und eine Gasdüse (204) aufweist,
- der Elektrodenhauptkörper (201) eine Entladungsfläche auf einer Außenumfangsfläche davon und einen innerhalb vorgesehenen Magneten (101) aufweist, der konfiguriert ist, um ein tunnelförmiges Magnetfeld zu bilden, das den Elektrodenhauptkörper (201) auf der Entladungsfläche kontinuierlich umgibt, wenn der Elektrodenhauptkörper (201) von der Seite des Trägermechanismus aus betrachtet wird,
- der Elektrodenhauptkörper (201) ferner eine Kathode (103), die die Entladungsfläche auf einer Oberfläche davon aufweist, und ein Joch (102) aufweist, das konfiguriert ist, um einen vom Magneten (101) erzeugten Magnetfluss auf die Kathode (103) zu induzieren,
- die Erdungselemente (202) mindestens einem Teil der Entladungsfläche mit einem Spalt dazwischen zugewandt und einander zugewandt sind, um den Elektrodenhauptkörper (201) dazwischen einzuschließen,
- die Entladungsfläche die Außenumfangsfläche des Elektrodenhauptkörpers (201) entweder mit oder ohne dazwischenliegendem Spalt umgibt, wenn der Elektrodenhauptkörper (201) von der Seite des Trägermechanismus aus betrachtet wird,
- die Gasdüse (204) so konfiguriert ist, dass sie ein Gas in einer Richtung parallel zur elektrischen Entladungsfläche in einen elektrischen Entladungsraum zwischen dem Erdungselement (202) und der dem Erdungselement (202) zugewandten elektrischen Entladungsfläche einleitet,
- der Trägermechanismus so konfiguriert ist, dass er ein Substrat (203) trägt, das in einer Position angeordnet ist, die vom Elektrodenhauptkörper (201) entfernt ist und die in Strömungsrichtung des aus der Gasdüse (204) abgegebenen Gases stromabwärts liegt.

2. Plasma-CVD-Vorrichtung nach Anspruch 1, wobei die Plasmabearbeitungselektrode einen Hilfsmagnetpol aufweist, dessen äußeres Seitenende außen über die elektrische Entladungsfläche des Elektrodenhauptkörpers hinausragt.

3. Plasma-CVD-Vorrichtung nach einem der vorhergehenden Ansprüche, wobei das Erdungselement (202) den Elektrodenhauptkörper umgibt.

4. Plasma-CVD-Vorrichtung nach einem der vorhergehenden Ansprüche, wobei die Quellgasdüse (205) gegenüber der Gasdüse (204) in Bezug auf den elektrischen Entladungsraum vorgesehen ist.

5. Plasma-CVD-Vorrichtung nach einem der Ansprüche 1 bis 3, wobei die Quellgasdüse (205) in einem Raum zwischen dem Elektrodenhauptkörper und der Position zum Platzieren eines Substrats (203), das von dem Trägermechanismus getragen wird, vorgesehen ist.

6. Plasma-CVD-Vorrichtung nach einem der vorhergehenden Ansprüche, wobei ein Mindestabstand zwischen der Position zum Platzieren eines Substrats (203), das von dem Trägermechanismus getragen wird, und dem Elektrodenhauptkörper 30 mm oder mehr und 300 mm oder weniger beträgt.

7. Plasma-CVD-Vorrichtung nach einem der vorhergehenden Ansprüche, wobei ein elektrisch geerdetes Netz mit einer Öffnungsrate von 50% oder mehr zwischen dem Elektrodenhauptkörper und der Position zum Platzieren eines Substrats (203), das von dem Trägermechanismus getragen wird, vorgesehen ist.

8. Herstellungsverfahren eines Substrats (203) mit einem dünnen Film, umfassend:
- Bereitstellen einer Plasma-CVD-Vorrichtung gemäß einem der vorhergehenden Ansprüche;
- einen Plasmaerzeugungsschritt zum Erzeugen eines Plasmas in der Plasma-CVD-Vorrichtung;
- einen Gaszufuhrschritt zum Auflösen des eingebrachten Gases durch das Plasma von der Gasdüse (204) und zum Zuführen eines erzeugten Radikals auf das Substrat (203);
- einen CVD-Quellgaszufuhrschritt zum Zuführen des von der Quellgasdüse (205) eingebrachten CVD-Quellgases auf das Substrat (203), um einen dünnen Film auf dem Substrat (203) abzuscheiden.

## Revendications

1. Dispositif de CVD assisté par plasma,
- comprenant :
- une chambre à vide,
- une électrode de CVD prévue dans la chambre à vide, et
- un mécanisme de support,
- dans lequel :
- l'électrode de CVD comprend une électrode de traitement au plasma et une buse de gaz source (205) configurée pour introduire un gaz source CVD au voisinage d'un corps principal d'électrode (201) de l'électrode de traitement au plasma,
- l'électrode de traitement au plasma comprend le corps principal d'électrode (201), des éléments de masse (202) et une buse de gaz (204),
- le corps principal d'électrode (201) comprend une surface de décharge sur une surface périphérique externe de celui-ci et un aimant (101) prévu à l'intérieur configuré pour former un champ magnétique en forme de tunnel entourant en continu le corps principal d'électrode (201), en regardant le corps principal d'électrode (201) depuis le côté du mécanisme de support, sur la surface de décharge,
- le corps principal d'électrode (201) comprend en outre une cathode (103) comprenant la surface de décharge sur une surface de celle-ci et une culasse (102) configurée pour induire un flux magnétique généré par l'aimant (101) sur la cathode (103),
- les éléments de masse (202) font face à au moins une partie de la surface de décharge avec un écart entre eux et se font face de manière à prendre en tenaille le corps principal d'électrode (201) entre eux,
- la surface de décharge entoure la surface périphérique externe du corps principal d'électrode (201), avec ou sans écart interposé entre eux, en regardant le corps principal d'électrode (201) depuis le côté du mécanisme de support,
- la buse de gaz (204) est configurée pour introduire un gaz dans une direction parallèle à la surface de décharge électrique dans un espace de décharge électrique entre l'élément de masse (202) et la surface de décharge électrique faisant face à l'élément de masse (202), et
- le mécanisme de support est configuré pour supporter un substrat (203) placé dans une position qui est éloignée du corps principal d'électrode (201) et qui est en aval dans une direction d'écoulement du gaz déchargé depuis la buse de gaz (204).

2. Dispositif de CVD assisté par plasma selon la revendication 1, dans lequel l'électrode de traitement au plasma comprend un pôle magnétique auxiliaire dont l'extrémité latérale externe fait saillie plus vers l'extérieur que la surface de décharge électrique du corps principal d'électrode.

3. Dispositif de CVD assisté par plasma selon l'une quelconque des revendications précédentes, dans lequel l'élément de masse (202) entoure le corps principal d'électrode.

4. Dispositif de CVD assisté par plasma selon l'une quelconque des revendications précédentes, dans lequel la buse de gaz source (205) est prévue à l'opposé de la buse de gaz (204) par rapport à l'espace de décharge électrique.

5. Dispositif de CVD assisté par plasma selon l'une quelconque des revendications 1 à 3, dans lequel la buse de gaz source (205) est prévue dans un espace entre le corps principal d'électrode et la position pour placer un substrat (203) supporté par le mécanisme de support.

6. Dispositif de CVD assisté par plasma selon l'une quelconque des revendications précédentes, dans lequel une distance minimale entre la position pour placer un substrat (203) supporté par le mécanisme de support et le corps principal d'électrode est supérieure ou égale à 30 mm et inférieure ou égale à 300 mm.

7. Dispositif de CVD assisté par plasma selon l'une quelconque des revendications précédentes, dans lequel une maille électriquement mise à la masse ayant un taux d'ouverture de 50% ou plus est prévue entre le corps principal d'électrode et la position pour placer un substrat (203) supporté par le mécanisme de support.

8. Procédé de fabrication d'un substrat (203) avec un film mince, comprenant :
- la fourniture d'un dispositif de CVD assisté par plasma selon l'une des revendications précédentes ;
- une étape de génération de plasma pour générer un plasma dans le dispositif de CVD assisté par plasma ;
- une étape d'amenée de gaz pour dissocier le gaz introduit à travers le plasma depuis la buse de gaz (204) et amener un radical généré sur le substrat (203) ;
- une étape d'amenée de gaz source CVD pour amener le gaz source CVD introduit à partir de la buse de gaz source (205) sur le substrat (203) afin de déposer un film mince sur le substrat (203).
